# FASCICULE DE BREVET EUROPEEN

(11) **EP 2 593 593 B1**
(45) Date de publication et mention de la délivrance du brevet: **19.11.2014**
(21) Numéro de dépôt: 11744038.8
(22) Date de dépôt: 01.07.2011
(51) Int. Cl.: C30B 11/04, C30B 15/04

(54) **PROCÉDÉ DE DOPAGE D'UN MATÉRIAU SEMI-CONDUCTEUR**
VERFAHREN ZUR DOTIERUNG EINES HALBLEITERMATERIALS
METHOD FOR DOPING A SEMICONDUCTOR MATERIAL

(30) Priorité: 16.07.2010 FR 1003009
(43) Date de publication de la demande: 22.05.2013
(73) Titulaire: "Apollon Solar", 69002 Lyon (FR); Siltronix, 74160 Archamps (FR)
(72) Inventeur: FORSTER, Maxime, F-69001 Lyon (FR); FOURMOND, Erwann, F-69100 Villeurbanne (FR); STADLER, Jacky, F-74930 Reignier (FR); EINHAUS, Roland, F-38300 Bourgoin Jallieu (FR); LAUVRAY, Hubert, F-92250 La Garenne Colombes (FR)
(74) Mandataire: Talbot, Alexandre
(86) Numéro de dépôt international: PCT/FR2011/000385
(87) Numéro de publication internationale: WO 2012/007653

(56) Documents cités:
- DE-A1-102005 032 790
- JP-A- 4 046 097
- US-A1- 2001 015 167
- US-B1- 6 179 914

## Description

### Domaine technique de l'invention

L'invention est relative à un procédé de dopage d'un matériau semi-conducteur.

### État de la technique

Dans le domaine de l'électronique et du photovoltaïque, il est important de contrôler la quantité d'impuretés dopantes présente à l'intérieur de la matrice cristalline d'un matériau semi-conducteur.

Devant la difficulté à réaliser un matériau semi-conducteur comportant les concentrations voulues en impuretés électriquement actives, l'industrie a choisi de les éliminer afin d'obtenir des matériaux très faiblement dopés. Une fois que le matériau est débarrassé de ces impuretés, il est mis en forme puis de nouveau dopé avec d'autres techniques qui assurent un meilleur contrôle du niveau de dopants.

Cette méthode de réalisation est longue et coûteuse car elle nécessite d'éliminer des impuretés dopantes qui seront réintroduites par la suite à la concentration désirée.

Lorsque l'on souhaite incorporer des dopants dans un matériau semi-conducteur, ces dopants sont incorporés, avant la cristallisation, soit dans la charge fondue, soit dans la charge avant l'étape de fusion. Cependant, dans un cas comme dans l'autre, la quantité finale de dopants dans le matériau semi-conducteur cristallisé ne correspond pas toujours à la quantité déposée dans le creuset. Différentes méthodes d'introduction des dopants sont utilisées couramment, mais ces méthodes sont toutes associées à des risques de contamination et/ou à des problèmes de contrôle de la quantité exacte de dopants incorporés. De même, la répartition des dopants dans le creuset n'est pas homogène ce qui pose des inégalités de propriété électrique dans le matériau semi-conducteur.

### Objet de l'invention

On constate qu'il existe un besoin de prévoir un procédé de dopage des matériaux semi-conducteur qui soit facile à mettre en oeuvre, économique et qui assure une bonne maîtrise de la quantité de dopants incorporés.

Le procédé selon l'invention est caractérisé par le fait qu'il comporte les étapes suivantes :
- prévoir un creuset contenant une charge dudit matériau semi-conducteur,
- disposer un matériau dopant dans un récipient sacrificiel fermé, le récipient sacrificiel étant formé par ledit matériau semi-conducteur,
- fondre le contenu du creuset.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels la figure unique représente, en coupe de manière schématique un creuset comportant une charge de matériau semi-conducteur muni d'un récipient sacrificiel.

### Description d'un mode de réalisation préférentiel de l'invention

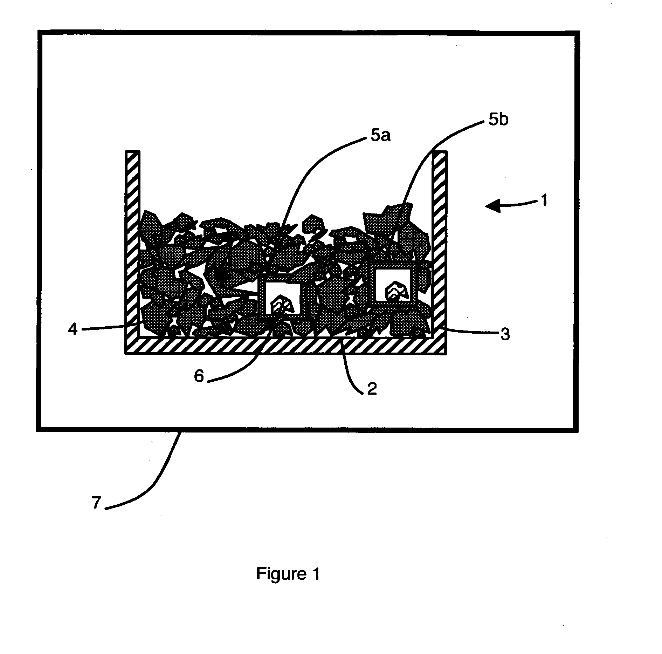

Comme illustré à la figure 1, le creuset 1 comporte un fond 2 et des parois latérales 3. Le creuset 1 est rempli par une charge 4 en matériau semi-conducteur. Le matériau semi-conducteur est par exemple, du silicium, un alliage de silicium-germanium, du SiC, un composé binaire de type III-V ou II-VI comme GaAs ou CdTe ou encore un composé ternaire de type III-V ou II-VI comme AlGaAs ou HgCdTe.

Selon le secteur technologique visé, la charge 4 en matériau semi-conducteur comporte des niveaux d'impuretés dopantes électriquement actives bien définies. Ces niveaux d'impuretés sont définis de manière à fournir un matériau semi-conducteur solide compatible avec l'application choisie. Pour une application de type microélectronique, la charge 4 de matériau semi-conducteur est très faiblement dopée. Pour une application de type photovoltaïque, la charge 4 de matériau semi-conducteur peut contenir plus d'impuretés dopantes. La répartition des impuretés dans la charge 4 est libre avant fusion. La charge 4 peut contenir du matériau semi-conducteur très faiblement dopé à côté d'un bloc de matériau semi-conducteur plus fortement dopé. La charge 4 peut contenir également un ou plusieurs blocs de matériau dopant à l'intérieur du creuset 1.

Afin d'obtenir, au final, la concentration désirée de dopants dans le matériau cristallisé, la charge 4 est analysée afin de mesurer la quantité de matériau semi-conducteur présent, la quantité de dopants présents et la quantité d'impuretés à incorporer. Cette étape peut être réalisée à tout moment avant la fusion de la charge.

Un récipient 5 sacrificiel fermé contenant un ou plusieurs matériaux dopants 6 est placé dans la charge 4 de matériau semi-conducteur à l'intérieur du creuset 1. Dans un mode de réalisation particulier, une pluralité de récipients 5 sacrificiels fermés sont introduits dans la charge 4. La répartition des récipients peut être quelconque ou choisi de manière à obtenir dès le départ de la fusion une très bonne homogénéité. Le récipient sacrificiel additionnel présent dans la charge peut contenir le dopant ou mélange de dopant que le récipient sacrificiel. Dans un autre mode de réalisation, le récipient sacrificiel additionnel contient des dopants différents du récipient sacrificiel additionnel.

L'utilisation de plusieurs récipients 5a, 5b contenant les mêmes dopants ou des dopants différents permet de favoriser l'homogénéité dans la charge fondue. Cela permet également d'utiliser des récipients 5a, 5b ayant des températures de fusion différentes et donc d'incorporer graduellement les dopants dans la charge ou d'éviter l'incorporation simultanée de deux dopants différents. Il est alors intéressant d'utiliser des récipients sacrificiels 5 qui présentent, entre eux, des températures de fusion différentes.

Le récipient 5 est sacrificiel car il va être fondu pour faire partie de la charge 4 à l'état liquide qui va donner le matériau semi-conducteur cristallisé. Le récipient sacrificiel 5 est formé par un matériau formant une partie de la charge 4. Le matériau constituant le récipient 5 fermé est, de préférence, le matériau semi-conducteur à fondre. Ce matériau semi-conducteur peut être dopé ou non. Cependant, il est également possible de former le récipient 5 fermé par un autre matériau, par exemple, par une impureté dopante à incorporer.

Dans un mode de réalisation préférentiel, le récipient sacrificiel 5 est formé dans un matériau qui présente une température de fusion proche ou égale à la température de fusion du constituant principal de la charge 4 à fondre. De cette manière, le récipient sacrificiel 5 ne se dégrade pas avant qu'une quantité suffisante de matériau fondu provenant de la charge 4 l'entoure et/ou le surmonte.

De manière préférentielle, les dimensions du récipient sacrificiel 5 sont également choisies de manière à ce que la libération du matériau dopant 6 intervienne lorsqu'une quantité suffisante de matériau fondu soit présente. Les dimensions du récipient dépendent de la granulométrie du dopant. De manière préférentielle, le volume du récipient 5 est compris entre quelques millimètres cubes et quelques centimètres cubes. Cependant, des dimensions supérieures sont utilisables même s'il devient préférable de travailler avec plusieurs récipients 5.

Une fois la charge 4 de matériau semi-conducteur placée dans le creuset 1 avec le récipient fermé 5 contenant un ou plusieurs dopants, la charge 4 est fondue. Le récipient sacrificiel 5 est également fondu ce qui libère les dopants 6 placés à l'intérieur du récipient 5. De cette manière, les impuretés dopantes 6 sont incorporées dans le bain fondu à l'intérieur du creuset 1. Tout le contenu du creuset 1 est fondu et sert à former le matériau semi-conducteur cristallisé.

L'utilisation d'un récipient sacrificiel 5 fermé contenant au moins une impureté dopante 6 est particulièrement avantageuse. L'impureté dopante 6 peut être à l'état de corps pur ou d'alliage.

Lorsque le récipient sacrificiel 5 présente une température de fusion identique ou sensiblement identique à celle du reste de la charge 4, le matériau dopant 6 est incorporé directement à la charge 4 fondue. Ceci réduit fortement les problèmes d'évaporation des matériaux dopants lors de la rampe en température du creuset 1, par exemple lorsque des dopants présentent une température de fusion inférieure à celle du matériau semi-conducteur constituant la charge sont à incorporer. Ce mode de réalisation peut être amélioré en rendant étanche le récipient sacrificiel 5.

L'utilisation d'un récipient étanche est encore plus avantageuse lorsque le creuset 1 est disposé dans une enceinte 7 sub-atmosphérique et même sous-vide. A titre d'exemple, ce mode de réalisation est particulièrement avantageux lorsque la pression de travail est comprise entre la pression atmosphérique et 10⁻⁵mbar. Le travail à basse pression est difficile voire impossible lorsque l'on cherche à incorporer des dopants 6 ayant une pression de vapeur saturante élevée, par exemple le gallium ou le phosphore.

Il est alors possible de réaliser une montée en température de la charge 4 à pression réduite, typiquement dans la gamme de pression décrite plus haut, de manière à éliminer les impuretés parasites et de réaliser ensuite la fusion à une pression plus élevée afin d'éviter l'évaporation des impuretés dopantes 6 introduites volontairement dans la charge 4.

Comme les impuretés dopantes 6 sont introduites directement dans le bain fondu, leur incorporation dans le matériau semi-conducteur est mieux contrôlée. Il en ressort une plus grande précision dans la quantité de dopants présente dans le matériau final car les pertes sont réduites, et une plus grande homogénéité des dopants à l'intérieur du bain fondu et donc du matériau cristallisé. De plus, les impuretés dopantes 6 étant incorporées dans le creuset 1 avant l'étape de fusion, il n'est plus nécessaire de les introduire au cours du procédé de fusion ce qui élimine les risques de contamination lors de l'introduction des impuretés, par exemple au moyen d'une canne. Cela permet également une simplification des équipements utilisables pour réaliser la fusion de la charge 4.

Un récipient sacrificiel 5 contenant des dopants 6 peut être utilisé dans un grand nombre de technologies où l'on retrouve l'introduction d'un matériau solide dans un creuset, la fusion de ce matériau solide et sa solidification. Les dopants classiques des matériaux semi-conducteurs peuvent être introduits dans le récipient sacrificiel 5, par exemple, le bore, le phosphore, le gallium, l'indium et le germanium. De manière avantageuse, les dopants présentant un point de fusion faible par rapport au reste de la charge et/ou une pression de vapeur saturante incompatible avec le procédé de fusion sont encapsulés dans le récipient 5.

Le récipient sacrificiel 5 est réalisé par toute technique adaptée, par exemple, par taraudage d'un bloc de matériau semi-conducteur constituant la charge 4 ou au moyen d'un autre technique d'usinage.

Le récipient sacrificiel 5 peut être formé par un matériau pur, un alliage ou un matériau dopé. Le dopant 6 contenu dans le récipient sacrificiel 5 est un matériau différent de celui du récipient. De manière préférentielle, le dopant 6 est un matériau pur ou sensiblement pur.

Dans un mode de réalisation préférentiel, le récipient sacrificiel 5 est disposé à l'intérieur de la charge 4 plutôt qu'en contact avec le fond 2, les parois latérales 3 et le sommet de la charge. De manière encore plus préférentielle, le récipient sacrificiel 5 est disposé entre le tiers supérieur et le tiers inférieur de la charge 4 à fondre. Ceci permet d'obtenir une fusion retardée du récipient sacrificiel 5 par rapport à la charge 4. Il est également possible de disposer le récipient dans le tiers inférieur pour éviter que le récipient ne surnage trop facilement.

Dans une variante de réalisation, le récipient sacrificiel ou les récipients sacrificiels sont introduits dans la charge après l'étape de fusion. De cette manière, les dopants sont introduits après fusion de la charge. Comme dans les modes de réalisations différents, les récipients peuvent incorporer différents dopants entre eux ou différents mélanges de dopants afin d'éviter des réactions parasites. Le récipient permet une meilleure introduction du dopant dans le coeur de la charge avant de passer à l'état fondu.

Dans la mesure où la quantité de dopants perdue par évaporation est réduite, il est possible d'obtenir un matériau semi-conducteur cristallisé dont la concentration en dopants apportés est très faible et très bien maîtrisée.

## Revendications

1. Procédé de dopage d'un matériau semi-conducteur **caractérisé en ce qu'**il comporte les étapes consécutives suivantes :
- prévoir un creuset (1) contenant une charge (4) dudit matériau semi-conducteur,
- disposer un matériau dopant (6) dans un récipient sacrificiel (5) fermé, le récipient sacrificiel (5) étant formé par ledit matériau semi-conducteur,
- introduire le récipient (5) dans le creuset (1)
- fondre le contenu du creuset (1).

2. Procédé selon la revendication 1, **caractérisé en ce que** le récipient sacrificiel (5) fermé est étanche.

3. Procédé selon l'une des revendications 1 et 2, **caractérisé en ce que** le creuset (1) est disposé dans une enceinte (7) travaillant à pression sub-atmosphérique.

4. Procédé selon l'un quelconque des revendications 1 à 3, **caractérisé en ce que** le récipient sacrificiel (5) fermé est disposé dans le tiers inférieur de la charge (4) en matériau semi-conducteur.

5. Procédé selon l'une quelconque des revendications 1 à 4, **caractérisé en ce qu'**il comporte l'utilisation d'un récipient sacrificiel (5a, 5b) additionnel.

6. Procédé selon la revendication 5, **caractérisé en ce que** le récipient sacrificiel (5a) et le récipient sacrificiel (5b) additionnel présentent des températures de fusion différentes.

## Patentansprüche

1. Verfahren zur Dotierung eines Halbleitermaterials, **dadurch gekennzeichnet, dass** es die folgenden aufeinanderfolgenden Schritte umfasst:
- Vorsehen eines Tiegels (1), der eine Ladung (4) des Halbleitermaterials enthält,
- Anordnen eines Dotierungsmaterials (6) in einem geschlossenen Opferbehälter (5), wobei der Opferbehälter (5) durch das Halbleitermaterial gebildet ist,
- Einbringen des Behälters (5) in den Tiegel (1),
- Schmelzen des Inhalts des Tiegels (1).

2. Verfahren nach Anspruch 1, **dadurch gekennzeichnet, dass** der geschlossene Opferbehälter (5) dicht ist.

3. Verfahren nach einem der Ansprüche 1 und 2, **dadurch gekennzeichnet, dass** der Tiegel (1) in einem unter subatmosphärischem Druck arbeitenden Raum (7) angeordnet ist.

4. Verfahren nach einem der Ansprüche 1 bis 3, **dadurch gekennzeichnet, dass** der geschlossene Opferbehälter (5) im unteren Drittel der Ladung (4) aus Halbleitermaterial angeordnet ist.

5. Verfahren nach einem der Ansprüche 1 bis 4, **dadurch gekennzeichnet, dass** es die Verwerdung eines zusätzlichen Opferbehälters (5a, 5b) umfasst.

6. Verfahren nach Anspruch 5, **dadurch gekennzeichnet, dass** der Opferbehälter (5a) und der zusätzliche Opferbehälter (5b) unterschiedliche Schmelztemperaturen aufweisen.

## Claims

1. A method for doping a semiconductor material **characterized in that** it comprises the following steps:
- providing a crucible (1) containing a feedstock (4) of said semiconductor material,
- disposing a dopant material (6) in a closed sacrificial recipient (5), the sacrificial recipient (5) being formed by said semiconductor material,
- inserting the recipient (5) in the crucible (1),
- melting the content of the crucible (1).

2. The method according to claim 1, **characterized in that** the closed sacrificial recipient (5) is hermetically tight.

3. The method according to one of claims 1 and 2, **characterized in that** the crucible (1) is placed in an enclosure (7) operating at sub-atmospheric pressure.

4. The method according to any one of claims 1 to 3, **characterized in that** the closed sacrificial recipient (5) is located in the bottom third of the feedstock (4) of semi-conductor material.

5. The method according to any one of claims 1 to 4, **characterized in that** it comprises the use of an additional sacrificial recipient (5a, 5b).

6. The method according to claim 5, **characterized in that** the sacrificial recipient (5a) and the additional sacrificial recipient (5b) present different melting temperatures.
